# EUROPEAN PATENT SPECIFICATION

(11) **EP 3 969 280 B1**
(45) Date of publication and mention of the grant of the patent: **14.01.2026**
(21) Application number: 20724878.2
(22) Date of filing: 15.05.2020
(51) Int. Cl.: B32B 37/00, B32B 37/12, B32B 38/10, B32B 37/10, B32B 7/12, B32B 7/06, B32B 37/14, B32B 5/02, B32B 23/08, B32B 27/10, B32B 27/32, B32B 27/08, B32B 27/12, B32B 27/36, B32B 29/08

(54) **PROCESS FOR MAKING MULTILAYER STRUCTURE WITH BARRIER PROPERTIES**
VERFAHREN ZUR HERSTELLUNG EINER MEHRSCHICHTIGEN STRUKTUR MIT BARRIEREEIGENSCHAFTEN
PROCÉDÉ DE FABRICATION DE STRUCTURE MULTICOUCHE À PROPRIÉTÉS BARRIÈRE

(30) Priority: 15.05.2019 NL 2023146
(43) Date of publication of application: 23.03.2022
(73) Proprietor: Knowfort Holding B.V., 6167 RD Geleen (NL)
(72) Inventor: JAHROMI, Shahab, 6211 RP Maastricht (NL)
(74) Representative: Hoyng Rokh Monegier B.V.
(86) International application number: PCT/EP2020/063666
(87) International publication number: WO 2020/229675

(56) References cited:
- EP-A1- 2 409 848
- WO-A1-2016/014027

## Description

The invention relates to a process for making a multilayer structure with barrier properties.

### Background of the invention

In a number of industries, barrier properties with respect to e.g. oxygen transmission and water vapor transmission are important. For instance, in the food and feed industry, oxygen barrier is important to preserve food and feed products. In the display industry, also high oxygen barrier is important to protect oxygen sensitive chemical compounds. For both applications, the barrier properties of single thin layer plastics are generally insufficient. Hence, so-called barrier layers are applied on these substrates in order to improve these barrier properties.

To improve the barrier performance, the barrier layers are directly applied on the substrate. In such cases, the barrier performance depends on the nature of the substrate. The barrier performance is better on smooth surfaces with good dimensional stability and less good on flexible substrates with rough surface topology. This is because on dimensionally stable substrates with smooth surfaces defect free and coherent barrier layers can be formed resulting in higher barrier values. It is therefore a problem to provide good barrier on substrates with irregular surface topology and flexible substrates. Even for smooth and dimensionally stable substrates it would be beneficial to improve the barrier performance if the quality of the barrier layer can be improved by for example decreasing the number of defects in the barrier layer. There is therefore a need for a method for providing good barrier layer independent or less dependent on the quality of the substrate.

Environmentally friendly substrates such as paper are among the substrates on which it is difficult to provide good barrier because of the rough surface topology generated by cellulose fibers. Also, flexible polymers such as polyethylene are not very suitable as the substrate for application of barrier systems.

In addition to, and independently from the above described considerations, there is a trend that because of environmental considerations the use of plastics is becoming more and more undesirable primarily in food and feed industry. Accordingly, there is a drive to replace fossil-based plastics by biopolymers and biodegradable/bio-based plastic products. In case biopolymers and bio-based plastic products cannot meet the required performance targets, efforts are being made to replace plastics which are notoriously difficult to recycle, such as polyester, with plastics which are more friendly as far as recyclability issues are concerned, such as polyolefin.

In the category of bio-based materials, paper, paperboard or other cellulose based materials are the main candidates. Polyethylene and polypropylene are the main contenders in the category of fossil-based plastics as far as easy recyclability is concerned. While these materials are relatively environmentally friendly, and are widely used in packaging industry, these materials have poor barrier properties.

Traditionally, a primary method for adding barrier property to a paper packaging material has been to extrusion-laminate over, or attach to, a paper base material (base paper), a barrier layer comprising an aluminum foil or metal deposition film constituted by aluminum or other metal, a polyvinyl alcohol (PVOH) or ethylene-vinyl alcohol copolymer (EVOH), polyvinylidene chloride (PVdC), polyacrylonitrile, and the like.

Document US 2013/129992 A1 discloses a method for making a multilayer structure.

The main problem with these methods is that they mainly use difficult to recycle substances. Aluminum foil and PVdC are among the most difficult materials as far as their environmental impact is concerned. This is because when these materials are incinerated, incineration residue ends up clogging exhaust ports and the inside of the furnace resulting in the problem of a decrease in incineration efficiency in the case of aluminum, while in the case of polyvinylidene chloride, there is the problem of the generation of dioxins and other harmful substances.

Consequently, there is a great desire for substrates that are easily recyclable having effective barrier materials that have a minimal burden on the environment.

### Summary of the invention

It is an object of the invention to provide a defect free barrier layer on a substrate independent or less dependent on the quality of the substrate.

It is a further object of the invention to provide a good barrier layer on cellulose based substrates such as paper, paperboard and cardboard.

It is a further object of the invention to provide a good barrier layer on flexible substrates such as polyolefin.

It is further object of this invention to improve the quality of barrier layers as compared with the methods described in the state of the art.

It is an object of the invention to provide a multilayer structure having good barrier properties comprising at least an easy recyclable substrate such as a biodegradable /bio-based substrate or a polyolefin substrate, and an organic barrier layer.

One or more of the above objects are achieved with the current invention, providing a method for producing a multilayer structure comprising an organic barrier layer, adhesive layer and substrate, comprising the following steps
(a) providing a carrier film,
(b) wherein a major part of the surface of the carrier film is provided with a release agent chosen from (i) an organic release layer, which organic release layer has the capacity to effect a releasable bond from the surface of the carrier film and a non-releasable bond with the surface of an organic barrier layer to be applied on the release layer or (ii) a metal layer on the carrier film which adheres stronger to the carrier film than to the organic barrier layer,
(c) providing an organic barrier layer on the release agent,
(d) providing an adhesive layer on the organic barrier layer, and bonding the organic barrier layer with said adhesive to a substrate, and
(e) stripping said carrier film to form the multilayer structure.

In one preferred embodiment, the substrate is a biodegradable, bio-based substrate or a polyolefin substrate.

The organic barrier layer preferably is applied by vacuum deposition.

The organic barrier layer preferably is a crystalline organic compound, and most preferably melamine.

Very good barrier properties can be obtained when the carrier film is a polyester film, and preferably a metalized polyester film, as such film has a very smooth surface allowing the organic barrier layer to have very few defects, and therefore relatively high barrier characteristics.

### Detailed description of the invention

It has been found that by using organic barrier layers, barrier properties are maintained and may be even improved upon, after transferring the organic barrier layer onto a substrate, also when such substrate is for example cellulose fibrous material such as paper.

This was unexpected because transfer of a layer of vapor deposited metal (which acts as a barrier layer on for example a PET substrate) does not result in suitable barrier properties if the substrate is based on cellulose fibrous materials.

We have furthermore found that the process according the invention can be used to induce barrier properties onto soft polymeric substrates such as polyolefins, in particular polyethylene films.

We have furthermore found that the process according to the invention can be used to improve barrier properties even on substrates that can be utilized with direct vapor deposition methods.

Therefore, by using organic barrier layers, it was surprisingly possible to transfer good barrier coatings onto substrates.

The process will herein below also be denoted as 'the transfer process'.

### The carrier film with release agent

The carrier film preferably is a plastic film. Suitable examples of carrier films include polyethylene terephthalate such as biaxially oriented polyethylene terephthalate (PET); crystallized copolymers of polyethylene terephthalate and isophthalate; oriented polystyrene; polyvinyl fluoride; acetate coated paper; polyolefins like polypropylene such as biaxially oriented polypropylene (BOPP) and polyamides, such as biaxillay oriented polyamide (BOPA).

Alternatively, the carrier film can be a metal layer such as for example aluminum foil. The strength of such metal layer may be not adequate for high speed processing, and therefore, a carrier film comprising a plastic film is preferred. Accordingly, such carrier film consists preferably of a metal layer such as aluminum foil laminated with a plastic film such as PET

The carrier film preferably is PET.

The thickness of the carrier film is not critical: however, it is advantageous if a film having a thickness of between about 12 microns and 30 microns is employed. It is particularly noteworthy that under the broad range of conditions specified above, the carrier film may be used over and over again in the subject process, without the necessity for replacement or cleaning thereof, and without adverse effect upon any of the steps in this process. This presents an outstanding advantage.

The carrier film is provided with a release agent. The release agent may be a classical release layer, i.e. an organic release layer, which organic release layer has the capacity to effect a releasable bond from the surface of the carrier film and a non-releasable bond with the surface of an organic barrier layer to be applied on the release layer. The release agent also may be a vapor deposited metal layer on the carrier film which adheres stronger to the carrier film than to the organic barrier layer. Furthermore, it is possible to combine the two layers.

### Metal as release agent

In one preferred embodiment, the release agent is a metal layer on the film. Metallized films are available, and preferably include metallized PET, metallized BOPP and metallized BOPA.

In a further preferred embodiment, the carrier film is aluminum foil either as the substrate or as aluminum foil laminated onto PET.

This embodiment is preferred, because we found that surprisingly some organic barrier layers show poor adhesion on aluminum metallized surfaces. Therefore, for these organic barrier layers the use of an organic release layer was not necessary if the barrier layer was applied directly on metallized carrier film. So, in various embodiments the organic barrier layer was directly applied on metallized PET.

For example, in one preferred embodiment melamine was vacuum deposited on metallized PET. In the following step, multilayer structures (also denoted as laminates) were provided in which the melamine barrier layer was laminated with a solventless adhesive onto a recyclable substrate such as paper or PE. After curing of the adhesive, the metallized carrier was removed, forming the structure of: melamine/adhesive/substrate.

A particularly preferred metalized film is PET wherein the optical density (OD) of metallized PET was above 2.0, preferably above 3.0. The OD generally will be below 4.0. Such metalized PET has a very smooth surface, and is therefore very suitable to apply a defect free organic barrier layer.

In one preferred embodiment, a carrier film is provided, and this film is metallized inline with the vapor deposition of an organic barrier layer. In such a case, the risk of distortions or damage to the carrier film with release agent is lowest.

It may be advantageous to further apply an organic release layer, as will be disclosed below.

### Organic release layer

In another preferred embodiment, the release agent is an organic release layer, which organic release layer has the capacity to effect a weak, releasable bond from the surface of the carrier film and a strong, non-releasable bond with the surface of an organic barrier layer to be applied on the release layer. In case a metalized carrier film is used, these characteristics of releasably bonding apply to the metallized surface of the carrier film.

Suitable organic release layers include polyurethanes, solutions of phenol formaldehyde resin, solvent systems of polyesters and combinations such as methyl methacrylate, ethylene terephtalalate, ethylene isophthalate, water and solvent systems of polyvinyl acetate and polyvinyl chloride. In addition suitable release coatings are mentioned in US 2018/0105699. Suitable commercially available release layers include DORESCO RA series such as RA7346 and AQUASLIP 958 produced by Lubrizol Advanced Materials, WASHIN COAT TF Series produced by Washin-Chemical (https://www.washin-chemical.co.jp/english/coatings.html), and 00-WQ-25 TRANSFER COATING LOW SOLID produced by Sun Chemical.

In relation to the transfer process, it was found that in order to meet all or only part of said requirements it was preferred to apply a liquid organic release layer, i.e. release layer, that, after application on the carrier film has a contact angle of zero degrees to the carrier surface.

Furthermore, in order to deposit a uniform barrier layer, it is a preferred requirement of the process that the carrier film should be as smooth as possible. The carrier film preferably is selected such that the organic release layer forms a coherent coating.

It is a further requirement that the peel forces of adhesion between the carrier film and the organic release layer be as low as possible but that the shear forces of adhesion between the organic release layer and the carrier film should be sufficiently high to prevent damage to the release layer during processing.

In order for a release layer to have a low peel force with respect to a given carrier film, it is preferred that the lacquer does not interact chemically with the carrier film and that the intermolecular forces (which include dispersion forces, interaction of permanent dipoles, induction forces and hydrogen bonding) between the carrier film and the release layer should be as low as possible. Further, the carrier film surface should be as smooth as possible in order to reduce mechanical adhesion (also this surface provides the replica surface for the release layer in the composite structure). Preferably both the release layer and the carrier film should have an elongation at break of at least 10% in the machine direction.

The release layer will act as a protecting top coat after transfer of the barrier layer to the substrate, since said release layer is a top coat layer if it is considered as a coating for the organic barrier layer precipitated after having stripped the carrier film at the final stage of the process.

The organic release layer can be optically clear, but can be dyed or pigmented. Preferably, the release layer has good printability and good adhesion to the organic barrier layer.

The release layer composition may be utilized as a melt, solution, paste or lacquer. It may be applied by spreading with a knife, brushing, using a roller, calendering, casting, flexography, rotogravure or like methods.

An applied amount of from 0.3 to 5 grams per m² has been found especially desirable and convenient.

If required, said release layer may be heated: (i) to remove solvent, (ii) accelerate crosslinking, (iii) bring about coalescence and, (iv) control of crystallization. Furthermore, the carrier film must be able to withstand these processing conditions.

A function of said release layer is to prevent scratching during subsequent processing of the multilayer structure.

The release layer can be chosen to provide a low water vapor transmission rate and/or a low gas transmission rate and/or good heat sealability and/or good printability and/or provide barrier to UV light or other substances such as aroma and mineral oils (MOSH/MOAH).

In addition, to the basic release layer components, one or more secondary additives may be added selected from the group consisting of standard coloring agents, standard matting agents, standard printing agents, standard slipping agents, and standard ultraviolet light absorbing agents. The desirability of such an admixture is appreciated by those skilled in the art when it is understood that the release layer will become the outermost layer of the final laminar product produced. Accordingly, beneficial color, matting, slipping, and absorbing properties are afforded, depending upon the nature of the secondary additive(s) employed.

In accordance with yet another aspect of the invention, the release agent between the carrier film and the organic barrier layer includes waxes or wax-like materials.

Natural waxes may include Ouricury, which is similar to Carnauba and is obtained from the palm leaf, include Carnauba, which is an exudate from the pores of the leaves of the Brazilian wax palm; condelilla, which is obtained from the Condellilla plant found largely in Mexico; Esparto which is also known as Spanish Grass Wax and is found elsewhere in the Mediterranean region; Sugar Cane Wax made by extraction with Heptane in the production of sugar cane; Montan, which is obtained by extraction from lignite and peat; Ozocerite, also known as Ozokerite, which is a yellowish brown mineral wax occurring naturally as a mixture of solid hydrocarbons; and Beeswax.

Suitable synthetic waxes include those made by purifying Montan wax and synthetic paraffin wax. Another suitable synthetic wax is microwax which is characterized by a microcrystalline structure and is produced in a fashion similar to that of the synthetic paraffins.

Wax-like materials furthermore include metallic salts of fatty acids of at least eleven carbon atoms and preferably of at least eighteen carbon atoms such as stearates, oleates or linoleates of zinc, calcium, barium, magnesium, aluminum and zirconium. Such wax-like materials are sold in dry or water dispersed form.

### Providing the organic barrier layer

One or more organic barrier layers can be applied onto the carrier film with release agent by dry processes such as vacuum deposition or wet process processes such as liquid coating.

In particular we found that depositing organic barrier layer by vacuum deposition provides very good barrier properties.

The further description of the organic barrier coating and its processing is described further below.

### Binding to the substrate

The carrier film with release agent and organic barrier layer is thereafter bonded to the substrate.

Therefore, an adhesive layer is provided between the organic barrier layer and the substrate, and the organic barrier layer is bonded with said adhesive to said substrate. This can be a two-step process, providing an adhesive to either the substrate or the barrier layer, and thereafter adhering the substrate or the barrier layer with adhesive to the barrier layer or substrate. Preferably, this is a one-step process, in which an adhesive is provided between the barrier layer and the substrate, and the three layers are bonded together. This binding of the layers is generally denoted as laminating.

Suitable adhesives include rubber-phenolic systems, polyol and polyester-isocyanate systems, water-based adhesives, solvent based adhesives, solventless adhesives and thermoplastic polymers.

The use of thermoplastic polymers is preferred, as such polymers may aid in providing barrier properties.

The adhesive can be chosen to provide a low water vapor transmission rate and/or a low gas transmission rate and/or provide barrier to UV light or other substances such as aroma and mineral oils (MOSH/MOAH).

Binding, or laminating may be done according to the wet laminating, dry laminating or the solventless laminating (e.g., hot melts) methods. Lamination can also be carried out using a thermoplastic layer.

In accordance with a still further aspect of the invention the thermoplastic layer for lamination is selected from the class consisting of polyolefins, especially polyethylene, styrenes, styrene-polyolefin mixtures, polyamides, nitrostyrenes, vinyl acetate and copolymers including ethylene vinyl acetates, acrylics, and plasticized nitrocelluloses. A particularly suitable thermoplastic layer is a mixture of styrene and vinyl resins being, for example, 80 parts styrene butadiene and 20 parts vinyl acetate, or 80 parts styrene and 20 parts ethylene vinyl acetate.

In accordance with a still further aspect of the invention, a heated and softened thermoplastic is caused to flow by being subjected to pressure at the nip of two rollers which provide a force in the range from about 35 to 175 Newton per linear mm, preferably about 105 newton per linear mm. The two rollers are cooled so that the thermoplastic layer is first caused to flow and is then rendered nonflowable without the requirement for subsequent additional cooling.

### The substrate

The substrate generally is, like the carrier layer with the organic barrier layer, a continuous web or film.

The substrate used preferably has a smooth non-brittle surface.

If the substrate is paper the selected paper is strongly dependent on the end use. As the substrate, the following have been employed with particular beneficial results: (a) films or sheets of a fibrous material fabricated from a fibrous pulp, such as cardboard, paperboard, and paper; (b) films or sheets of a fibrous material such as non-woven fabrics, spun-bonded fabrics, and the like. Equally beneficial results are achieved with bonded fiber fleeces and the traditional woven and knitted textile fabrics having a "closed" surface); (c) films or sheets of commonly employed plastic materials such as polyethylene, polypropylene and cellophane.

In a preferred embodiment, the substrate is a recyclable substrate such as a substrate from biopolymers. Biopolymers include cellulose, lignin, polylactic acid (PLA), certain polyester and the like.

In case the substrate is paper, there are no particular limitations on the type of paper base material and can be suitably selected from printing paper or packaging paper corresponding to the application. Examples of the material of the paper base material include glassine paper, parchment paper, high-grade printing paper, intermediate-grade printing paper, low-grade printing paper, printing tissue paper, colored high-quality paper, art paper, coated paper, Kraft paper, container board, coated cardboard, ivory paper and cup base paper.

The basis weight of the paper base material is preferably 600 g/m² or less, more preferably 30 g/m² to 500 g/m², even more preferably 150 g/m² to 400 g/m², and most preferably 180 g/m² to 400 g/m².

If the basis weight of the paper base material is 400 g/m² or less, the stress when the multilayer structure is bent does not act on the organic barrier layer. Consequently, cracks attributable to that stress do not form in the organic barrier layer and there are no decreases in a gas barrier property. In addition, if the basis weight of the paper base material is 400 g/m² or less, cost increases can be suppressed.

In addition, in the case of using the organic barrier layer based on paper in ordinary packaging applications, the basis weight of the paper base material is preferably 180 g/m² or more. If the basis weight of the paper base material is 180 g/m² or more, the paper base material is able to maintain sufficient strength for ordinary packaging applications.

### Removing carrier film

The final multilayer structure is obtained after removing the carrier film.

In case the carrier film comprises a metal layer, the carrier film may be removed with the metal layer, to provide a bare organic barrier layer on the multilayer structure, if no organic release layer was used.

In case an organic release layer was used, the carrier film (optionally with metal layer) may be removed while leaving the organic release layer on the organic barrier layer, which can act as a protective coating.

### Processing

Transfer processing is known as such, as for example described in US4344998. However, several variations exist, as will be explained below.

An advantageous modification of the basic process is a procedure wherein both major surfaces of the carrier film are simultaneously coated with the a release agent, and the organic barrier layer is then simultaneously vapor deposited upon each coated surface of the carrier film; each vapor deposited layer of organic barrier layer is then bonded to a separate substrate by standard laminating techniques, whereby a bi-facial composite structure is produced; whereupon the two substrates are (simultaneously) removed from the carrier film to produce two organic barrier coated substrates.

Special advantages may also be achieved, if, simultaneously with the application of the laminating adhesive to the exposed surface of the vapor deposited organic layer, a second coating is applied--as by means of a roller to the free major surface of the carrier film. Thereby such surface will be ready for the start of a subsequent vacuum coating procedure according to this invention, after this process is completed.

The laminating adhesive may be applied to organic barrier layer by standard means, as by a roller partially submerged in a vessel containing the adhesive. Of course, other means such as spreading with a knife, brushing, coating, spraying, etc., may be employed. Suitable lamination lines for applications of the adhesive are for example Super Simplex SL and Super Combi 4000 produced by Nordmeccanica. The thickness of the layer of laminating adhesive is not critical and will vary with the nature of the adhesive employed. The thickness of adhesive must be sufficient to afford a bond of the organic barrier layer to the substrate. When the latter is a film or sheet fabricated from a fibrous pulp (e.g., cardboard or especially paper), a standard wet laminating adhesive may by employed. Of course, standard dry and solventless laminating techniques can be used, if desired. Solventless laminating is particularly preferred if organic barrier layer is melamine.

### Specific combinations

Among the useful organic release layer and carrier film combinations are polyvinylidene chloride copolymers in combination with polypropylene film, and polyvinylidene chloride copolymers in combination with polyvinylidene fluoride film. The latter combination is particularly desirable if low water vapor transmission rate and low oxygen gas transmission rate are desirable in the finished composite since the carrier film can be heated to temperatures up to 150°C to ensure optimum crystallization of the lacquer and hence low oxygen transmission and water vapor transmission properties being attained.

Another useful combination, which is preferred because no chlorine is present, is an acrylic copolymer with a polyester film or polypropylene film as the carrier film. This combination is particularly desirable if low water vapor transmission rate and heat seal resistance are required.

### The vapor deposited organic barrier layer

The organic barrier layer according to the invention may comprise in principle, any organic compound.

The organic barrier layer may be vapor deposited according to well-known methods. The organic compound preferably has a vapor pressure of about 1 Pa (0.01 mBar) or higher at 30 °C below its decomposition temperature. Preferably, the vapor pressure is about 10 Pa or higher. Generally, the vapor pressure will be about 1000 Pa (100 mBar) or lower.

For obtaining improved barrier properties, the compound preferably is crystalline, and has a Tm of 50 °C or more, preferably of about 100 °C or more. Furthermore it is preferred that the organic compound has a Tm (or Tg or rubbery-to-plastic phase-transition), of 70 °C or more, preferably of about 100 °C or more.

The Mw of the organic compound in general will be lower than 5000. Furthermore, the organic compound is preferably non-aliphatic (thus, it has ether, ester, amide, keton, alcohol, acid, amine groups and the like) such that the compound is sufficient polar to adhere well to the release layer.

The saturation pressure preferably is more than 4 times the square root of the molar mass of the compound divided by the absolute temperature at which the compound is evaporated in the evaporator.

The specific heat of sublimation preferably is about 0.5 kJ/g or higher, preferably about 0.6 kJ/g or higher. Generally, the specific heat of sublimation preferably is about 2 kJ/g or lower, more preferably about 1.5 kJ/g or lower, and most preferable about 1.2 kJ/g or lower. In a further preferred embodiment, the organic compound comprises one or more groups that have the ability to form hydrogen bonds, such as for example - NH2, -OH, -COOH, -NRH and the like.

In a further preferred embodiment, the organic compound comprises cyclic groups, such as one or more aromatic, cyclopentane, cyclopentene, cyclohexyl, admantane or cyclohexenyl groups; one or more aromatic groups are preferred.

In a further preferred embodiment, the cyclic ring comprises a heterogeneous atom like oxygen, sulphur and preferably nitrogen like pyrimidine.

In a further preferred embodiment, the organic compound comprises of two aromatic rings which are linked together by a flexible spacer unit. The flexible unit may contain -NH-, or - CH2- groups.

In one preferred embodiment of the invention, the crystalline organic compound is a triazine which may comprise in principle, any triazine compound, for example melamine, melam, melem, or melon. Preferably, the triazine compound is melamine.

Examples of suitable non-triazine compounds include derivatives from pyrimidine trione, pyran-2,4,6-triol, bipyridine, naphthalenehexol, diamino-dihydro-oxo-pyrimodine, myo-inositol, diazozspiro-decane-trione, benzenetriol, cyclohexanetricarboxilic acid, hydroxybenzene-carboxilic acid, pyridinedicarboxilic acid esters, 9-methylanthracene, 9-methylcarbazole, dibenzothiophene, nonanedioic acid, 4,4'-azoxyanisole, 4-hydroxybenzaldehyde, triphenylamine, 4,4'-dichlorodiphenylsulphone, adipic acid, p-phenylphenol, p-aminophenol, aluminiumacetoacetonate, 3-hydroxy benzoic acid, parylene and terephthalic acid.

The thickness of the organic compound layer as formed on the substrate in the vapour-depositing step depends on its intended purpose, and can thus vary within wide limits.

Preferably, the thickness of the layer is about 4000 nm or less, more preferably about 2000 nm or less. The minimum thickness is preferably about 2 nm or more, more preferably about 10 nm or more, and even more preferred about 75 nm or more The thickness can be for example between about 100 and about 2000 nm like for example, about 200 or about 1000 nm.

In a further embodiment, the organic compound consists of oligomeric materials. The molecular weights of the oligomeric organic compound in general will be higher than 500, preferably higher than 1000. The oligomeric organic compound may be polymerized on the surface, or applied without further polymerization. Generally, the molecular weight will be about 100,000 or lower, preferably about 50,000 or lower, and most preferably about 20,000 or lower. Generally, about 50 wt % of the oligomeric organic compound layer will have a molecular weight lower than about 30,000; preferably about 50 wt % of the organic oligomer will have a molecular weight of about 20,000 or lower. The molecular weight can be measured by gel permeation chromatography (GPC) using polystyrene as standard. The oligomeric organic compound may be both amorphous or exhibit crystalline behavior.

In one embodiment of the invention, the polymer or oligomer comprises polar groups. Suitable polymers with polar groups include polyvinyl acetate, polyvinylalcohol (PVOH), ethylene-vinyl alcohol copolymer (EVOH), thermoplastic polyester (like PET or PBT), polylactides, polyglycolides, polylactones, polyhydroxybutyrate-valerate polymers, polyamides (nylons), polycarbonates, ethylene-acrylic polymers, chlorinated polyethylenes, polyurethanes, styrenemaleic acid anhydride copolymers, vinylidene chloride polymers, copolymers of ethylene and vinyl alcohol, poly(ethylene glycol), polyvinyl pyrrolidone, polyvinyl alcohol, polyacrylic acid, polyacrylamides, N-(2-Hydroxypropyl) methacrylamide, Divinyl Ether-Maleic Anhydride, Polyoxazoline, Polyphosphates, Polyphosphazenes, and the like. Other polymers include natural water soluble polymers like Xanthan Gum, Pectins, Chitosan derivatives, Dextran, Carrageenan, Guar Gum, Hydroxypropylmethyl cellulose, Hydroxypropyl cellulose, Hydroxyethyl cellulose, Sodium carboxy methyl cellulose, Albumin, and Starch or Starch based derivatives.

Preferably, non-chlorinated polymers are used, as that increases the possibility of recycling and/or controlled incineration. More generally, preferably, non-halogenated polymers or oligomers are used in the methods and products of the inventions.

Preferably, PVOH, EVOH, PET, polyacrylates or polyamides are used.
In another embodiment, the polymer or oligomer is an a-polar polymer. Suitable a-polar polymers include polyolefins like polyethylene or polypropylene, and polystyrene. With these polymers, it is possible to introduce polar groups during the evaporation step with a plasma treatment using oxygen as plasma gas, in the space between the evaporator and the deposition surface.

The organic barrier layer may be vapor deposited according to well-known methods. Vapour-depositing as such is a process known to the skilled person and it is preferably carried out in a roll-to-roll process. The vapour-depositing step is carried out at a reduced pressure, i.e. a pressure below atmospheric pressure. In the process according to the invention, the pressure generally is below about 1000 Pa (10 mbar), preferably below about 100 Pa (1 mbar) even more preferably below about 10 Pa (0.1 mbar). In case the organic compound deposition takes place in a chamber in which metal or a metal-oxide is deposited, it is more preferable to have a pressure of below about 1 Pa (1×10⁻² mbar) although it is equally possible to reduce the pressure at which the vapour-depositing step is carried out even further. Generally, the vapour-depositing step for metal or metal oxides is carried out at a pressure of about 0.1 Pa (10⁻³ mbar) to 10⁻⁴ Pa (10⁻⁶ mbar). Vapour deposition of organic compound is preferably carried out at a pressure between 10 Pa to 0.01 Pa (1×10⁻¹ to 1×10⁻⁴ mbar).

During the vapour-depositing step, the temperature of the carrier film is about -60° C. or higher, preferably about -30° C. or higher, and even more preferable about -20° C. or higher, and most preferable about -15° C. or higher. The temperature of the carrier film generally will be about +125° C. or lower, preferably about +100° C. or lower, even more preferably about +80° C. or lower, and most preferably about 30° C. or lower. If the vapour-depositing step is done on a film which is guided over a temperature-controlled coating drum, the temperature of the carrier film is the temperature at which the coating drum is controlled, thus the temperature of the surface section of the film that is in immediate contact with the coating drum. In such a case, and in view of the fact that the to be deposited compounds often have a much higher temperature than 125° C., it will typically occur-as is known-that the temperature of the side of the film that is being deposited is higher than the temperature of the side that is not being deposited. Preferably, the carrier film is kept at a temperature of about 50° C. or lower.

One method of ensuring that the carrier film has a defined temperature is applicable in case there is at least one section, plane or side of the carrier film where no layer is to be vapor-deposited; the said section, plane or side can then be brought into contact with a cooled or heated surface to bring the temperature to a desired level and keep it there. As an example, in case the vapor-depositing step is executed as a semi-continuous or continuous process whereby the organic barrier layer will be deposited on one side of the carrier film with release agent, the said film preferably is guided over a temperature-controlled roll, also known as coating drum, in such a fashion that the other side of the film-where no layer will be deposited-is in contact with the temperature-controlled roll before and/or during and/or following the vapor-depositing step.

### Apparatus for applying the organic barrier layer

An apparatus suitable to implement the present invention in a roll-to-roll setup is an apparatus for depositing a metal or metal-oxide and an organic compound under vacuum on a substrate, comprising winding rolls and at least one vacuum chamber with a metal or metal-oxide deposition part and/or deposition of release layer and an organic compound deposition part, the organic compound deposition part comprising an organic compound evaporator.

Apparatus for vapor depositing metal, metal oxide and or melamine layers are known.

In a preferred embodiment, the vapor depositing apparatus comprises a vacuum chamber and a heater for evaporating the release agent and/or organic compound wherein the evaporator is heated by electrically powered heaters or by using high temperature control systems. One preferred high temperature control system is for example of the type i-Temp Plus produced by ICS Cool Energy, which offers precision-control of temperatures up to 400°C and is compatible with oil or steam heat transfer mediums. The advantage of oil heating system is that by using a thermostat oil can also be used for cooling the evaporator increasing the efficiency of the coating process.

In one embodiment, the evaporator is preferably placed outside the vacuum chamber, but it is linked by a heated gas into the vacuum chamber. This has the advantage that the evaporator can stay at the operating temperature when the vacuum chamber is opened to place the next roll which is to be coated. In this way the effective cycle times can be increased.

In a further embodiment the roll-to-roll vacuum deposition is carried out in an air-to-air system whereby the carrier film enters the vacuum chamber at atmospheric pressures and exits the chamber after being vacuum deposited with different layers, again to atmospheric pressure. This method has the advantage that vacuum deposition can be combined in-line with other processes such as lamination with the substrate thereby eliminating the use of vacuum deposition as batch process.

Preferably, the organic compound deposition part comprises a cooling drum. It is furthermore beneficial to separate by a partition wall the evaporation zone for metal (oxide) and/or release layer from evaporation zone for organic material. This would prevent mixing of various vapours which will results in better performance.

### A liquid deposited barrier film

As an alternative to vacuum deposition, an organic barrier coating can be applied at atmospheric conditions using liquid coating. Such liquid coating can be used together with a vacuum deposited organic compound to increase barrier properties.

Accordingly, thin liquid film coatings, for example barrier polymers that are coated in the form of a dispersion or solution in a liquid medium or solvent, onto a carrier substrate, and subsequently dried into thin barrier coatings. It is important that the dispersion or solution is homogeneous and stable, to result in an even coating with uniform barrier properties. Examples of suitable polymers for aqueous compositions are polyvinyl alcohols (PVOH), water-dispersible ethylene vinyl alcohols (EVOH) or polysaccharide-based water-dispersible or dissolvable polymers. Such dispersion coated or so-called liquid film coated (LFC) layers may be made very thin, down to tenths of a gram per m², and may provide high quality, homogenous layers, provided that the dispersion or solution is homogeneous and stable, i.e. well prepared and mixed. PVOH has excellent oxygen barrier properties under dry conditions and also provides very good odour barrier properties, i.e. capability to prevent odour substances from entering the packaging container from the surrounding environment, e.g. in a fridge or a storage room, which capability becomes important at long-term storage of packages. Furthermore, such liquid film coated polymer layers from water-dispersible or -dissolvable polymers often provide good internal adhesion to adjacent layers, which contributes to good integrity of the final packaging container. Suitably, the polymer may be selected from the group consisting of vinyl alcohol-based polymers, such as PVOH or water dispersible EVOH, polysaccharides such as for example starch or starch derivatives, microfibrillated cellulose (MFC), cellulose nanofibrils (CNF), nanocrystalline cellulose (NCC), hemicellulose or chitosan or other cellulose derivatives, water dispersible polyvinylidenechloride (PVDC) or water dispersible polyesters, or combinations of two or more thereof.

More preferably, the polymer binder is selected from the group consisting of PVOH, water dispersible EVOH, polysaccharides such as for example starch or starch derivatives, chitosan or other cellulose derivatives, or combinations of two or more thereof.

Such barrier polymers are thus suitably applied by means of a liquid film coating process, i.e. in the form of an aqueous or solvent-based dispersion or solution which, on application, is spread out to a thin, uniform layer on the substrate and thereafter dried.

Aqueous compositions generally have certain environmental advantages. Preferably, the liquid gas barrier composition is water-based, because such composition usually provides a better work environment friendliness than solvent-based systems, as well.

In a further embodiment, a polymer or compound with functional carboxylic acid groups may be included, in order to improve the water vapour and oxygen barrier properties of a PVOH coating. Suitably, the polymer with functional carboxylic acid groups is selected from among ethylene acrylic acid copolymer (EAA) and ethylene methacrylic acid copolymers (EMAA) or mixtures thereof. One particularly preferred barrier layer mixture consists of PVOH, EAA and an inorganic laminar compound. The EAA copolymer is then included in the barrier layer in an amount of about 1 -20 weight %, based on dry coating weight.

Other examples of polymer binders providing oxygen barrier properties, suitable for liquid film coating, are the polysaccharides, in particular starch or starch derivatives, such as preferably oxidised starch, cationic starch and hydroxpropylated starch. Examples of such modified starches are hypochlorite oxidised potato starch (Raisamyl 306 from Raisio), hydroxypropylated corn starch (Cerestar 05773) etc. However, also other starch forms and polysaccharide derivatives may provide gas barrier properties at some level.

Most preferably, however, the gas barrier polymer is PVOH, because it has all the good properties mentioned above, i.e. film formation properties, gas barrier properties, cost efficiency, food compatibility and odour barrier properties.

A PVOH-based gas barrier composition performs best when the PVOH has a degree of saponification of at least 98 %, preferably at least 99 %, although PVOH with lower degrees of saponification will also provide oxygen barrier properties.

According to a further embodiment, the liquid composition additionally may comprise inorganic particles in order to further improve the oxygen gas barrier properties.

The polymer binder material may for example be mixed with an inorganic compound which is laminar in shape, or flake-formed. By the layered arrangement of the flake-shaped inorganic particles, an oxygen gas molecule has to migrate a longer way, via a tortuous path, through the oxygen barrier layer, than the normal straight path across a barrier layer.

The inorganic laminar compound is a so-called nanoparticle compound dispersed to an exfoliated state, i.e. the lamellae of the layered inorganic compound are separated from each other by means of a liquid medium. Thus, the layered compound preferably may be swollen or cleaved by the polymer dispersion or solution, which at dispersion has penetrated the layered structure of the inorganic material. It may also be swollen by a solvent before added to the polymer solution or polymer dispersion. Thus, the inorganic laminar compound is dispersed to a delaminated state in the liquid gas barrier composition and in the dried barrier layer. There are many chemically suitable nano-clay minerals, but preferred nano-particles are those of montmorillonite, such as purified montmorillonite or sodium-exchanged montmorillonite (Na-MMT). The nano-sized inorganic laminar compound or clay mineral preferably has an aspect ratio of 50-5000 and a particle size of up to about 5 µm in the exfoliated state.

Suitable inorganic particles mainly consist of laminar bentonite particles having an aspect ratio of from 50 to 5000.

Preferably, the organic barrier layer includes from about 1 to about 40 weight %, more preferably from about 1 to about 30 weight % and most preferably from about 5 to about 20 weight %, of the inorganic laminar compound based on dry coating weight. If the amount is too low, the gas barrier properties of the coated and dried barrier layer will not be markedly improved compared to when no inorganic laminar compound is used. If the amount is too high, the liquid composition will become more difficult to apply as a coating and more difficult to handle in storage tanks and conduits of the applicator system. Preferably, the barrier layer includes from about 99 to about 60 weight %, more preferably from about 99 to about 70 weight % and most preferably from about 95 to about 80 weight % of the polymer based on the dry coating weight. An additive, such as a dispersion stabilizer or the like, may be included in the gas barrier composition, preferably in an amount of not more than about 1 weight % based on the dry coating. The total dry content of the composition is preferably from 5 to 15 weight-%, more preferably from 7 to 12 weight-%.

According to a different preferred embodiment, the inorganic particles mainly consist of laminar talcum particles having an aspect ratio of from 10 to 500. Preferably, the composition comprises an amount of from 10 to 50 weight-%, more preferably from 20 to 40 weight-% of the talcum particles, based on dry weight. Below 20 weight-%, there is no significant increase in gas barrier properties, while above 50 weight-%, the coated layer may be more brittle and breakable because there is less internal cohesion between the particles in the layer. The polymer binder seems to be in too low an amount to surround and disperse the particles and laminate them to each other within the layer. The total dry content of such a liquid barrier composition from PVOH and talcum particles may be between 5 and 25 weight-%. Surprisingly good oxygen barrier properties may be achieved when there is made use of colloidal silica particles, exhibiting a particle size of 3- 150 nm, preferably 4-100 nm and even more preferred 5-70 nm, which particles are preferably amorphous and spherical. The use of colloidal silica particles moreover has the advantage that the liquid barrier composition may be applied at a dry content of 15-40 weight %, preferably 20-35 weight % and even more preferred 24-31 weight %, whereby the demand on forcible drying is decreased.

Less preferred alternatives of inorganic particles according to the invention are particles of kaolin, mica, calcium carbonate etc.

The preferred polymer binder, also when employing inorganic particles for providing oxygen barrier properties, is PVOH, partly due to its advantageous properties mentioned above. In addition, PVOH is advantageous from a mixing point of view, i.e. it is generally easy to disperse or exfoliate inorganic particles in an aqueous solution of PVOH to form a stable mixture of PVOH and particles, thus enabling a good coated film with a homogeneous composition and morphology.

The oxygen gas barrier layer may be applied at a total amount of from 0,1 to 5 g/m², preferably from 0,5 to 3,5 g/m², more preferably from 0,5 to 2 g/m², dry weight. Below 0,5 g/m², there will likely not be any effect of further filling and closing pores on a substrate surface and no gas barrier properties achieved at all, while above 5 g/m², the coated layer will not bring cost-efficiency to the packaging laminate, due to high cost of barrier polymers in general and due to high energy cost for evaporating off the liquid. A recognizable level of oxygen barrier may be achieved by PVOH at 0,5 g/m² and above, and a good balance between barrier properties and costs is achieved between 0,5 and 3,5 g/m².

The oxygen gas barrier layer may be applied in two consecutive steps with intermediate drying, as two part-layers. When applied as two part-layers, each layer is suitably applied in amounts from 0,1 to 2,5 g/m², preferably from 0,5 to 1 g/m², and allows a higher quality total layer from a lower amount of liquid gas barrier composition. The two part-layers may be applied at an amount of from 0,5 to 2 g/m² each, preferably from 0,5 to 1 g/m² each.

### Combination of barrier layers

In a further embodiment organic barrier layer may consist of a combination of vacuum deposited layer and liquid coating layer.

In this case, preferably, a liquid barrier coating is first applied onto carrier film which is coated with a release layer. It is also possible to apply inline release layer and liquid barrier in sequence. The liquid barrier coating will be dried and/or hardened to provide this layer as solid barrier coating.

Subsequently on this barrier coating a second layer of organic barrier coating is vapor deposited. The first barrier coating can be for example PVOH optionally containing nano-particles. The vacuum depositable organic coating can be a triazine based compound, for example melamine.

In a further embodiment it is advantageous to first vacuum deposit a layer of metal, such as aluminum, or metal oxide, such as AlOx or SiOx, on the carrier substrate coated with the release layer followed by vacuum deposition of organic barrier layer such as melamine. The deposition of aluminum is particularly advantageous because it can introduce UV barrier and allow sealing by induction heating or ultrasonic heating or other conventional contact or convection heating means, e.g. hot air.

### Further processing

In a further embodiment the multilayer structure based on for example paper, paperboard or other cellulose containing materials, or easy recyclable polyolefines such as PE produced according to the invention can be used as such, or incorporated in a laminate, for use in liquid or semi-liquid packaging material.

The term "liquid or semi-liquid food" generally refers to food products having a flowing content that optionally may contain pieces of food. Dairy and milk, soy, rice, grains and seed drinks, juice, nectar, still drinks, energy drinks, sport drinks, coffee or tea drinks, coconut water, tea drinks, wine, soups, jalapenos, tomatoes, sauce (such as pasta sauce), beans and olive oil are some non-limiting example of food products contemplated.

In a further embodiment the multilayer structure based on paper, paperboard or other cellulose containing materials, produced according to the invention can be incorporated in a laminate used for aseptic packaging. The term "aseptic" in connection with a packaging material and packaging container refers to conditions where microorganisms are eliminated, in-activated or killed. Examples of microorganisms are bacteria and spores. Generally, an aseptic process is used when a product is aseptically packed in a packaging container. Aseptic processing is a processing technique wherein thermally sterilized liquid products (typically food or pharmaceutical) are packaged into previously sterilized containers under sterile conditions to produce shelf-stable products that do not need refrigeration

On the inside of the laminate, i.e. the side intended to face the filled food contents of a container produced from the laminate, there is an innermost layer, which innermost, inside layer may be composed of one or several part layers, comprising heat sealable thermoplastic polymers, such as adhesive polymers and/or polyolefins. Also, on the outside of the bulk layer, there is an outermost heat sealable polymer layer. The thermoplastic polymer of the innermost heat sealable layer may be a polyolefin, such as polyethylene, such as a blend of metallocene-catalysed linear low density polyethylene (m-LLDPE) and low density polyethylene (LDPE). When the innermost polyolefin layer is applied directly onto the cellulose based multilayer structure, it is seen that the barrier properties of the laminated material increases significantly.

Furthermore, the other side of the cellulose based multilayer structure may be laminated to the bulk layer by a bonding layer of a thermoplastic polymer, such as a polyolefin, such as polyethylene, such as low density polyethylene (LDPE). In this way, the cellulose based multilayer structure is encapsulated between polyolefin layers, such that the oxygen barrier properties of the laminated barrier paper material are increased even further. The extrusion is generally done at high temperatures such as, in the case of molten low density polyethylenes, up to about 330 °C.

In a further embodiment the multilayer structure for (aseptic) liquid packaging is based on easy recyclable polyolefin such as PE.

Suitable adhesive polymers for the bonding layers interior of the laminated material, i.e. between an outer heat sealable layer and the barrier- or release layer- coated substrate layer, are the so-called adhesive thermoplastic polymers, such as modified polyolefins, which are mostly based on LDPE or LLDPE co-polymers or, graft co-polymers with functional-group containing monomer units, such as carboxylic or glycidyl functional groups, e.g. (meth)acrylic acid monomers or maleic anhydride (MAH) monomers, (i.e. ethylene acrylic acid copolymer (EAA) or ethylene methacrylic acid copolymer (EMAA)), ethylene-glycidyl(meth)acrylate copolymer (EG(M)A) or MAH-grafted polyethylene (MAH-g-PE). Another example of such modified polymers or adhesive polymers are so called ionomers or ionomer polymers. Preferably, the modified polyolefin is an ethylene acrylic acid copolymer (EAA) or an ethylene methacrylic acid copolymer (EMAA).

Corresponding modified polypropylene-based thermoplastic adhesives or bonding layers may also be useful, depending on the requirements of the finished packaging containers. Such adhesive polymer layers or tie layers are normally applied together with the respective outer layer or further bulk-to-barrier bonding layers in a co-extrusion coating operation.

The adhesive may be applied as an aqueous adhesive solution or composition, and it may be applied onto one of the surfaces to be laminated to each other, and then joined with the other surface in a lamination station, involving one or more lamination pressure roller nips.

Suitable thermoplastic polymers for the outermost and innermost heat sealable liquid-tight layers in the laminated packaging material of the invention, are polyolefins such as polyethylene and polypropylene homo- or co-polymers, preferably polyethylene and more preferably polyethylene selected from the group consisting of low density polyethylene (LDPE), linear LDPE (LLDPE), single-site catalyst metallocene polyethylene (m-LLDPE) and blends or copolymers thereof. According to a preferred embodiment, the outermost heat sealable and liquid-tight layer is an LDPE, while the innermost heat sealable, liquid-tight layer is a blend composition of m-LLDPE and LDPE for optimal lamination and heat sealing properties. The outer- and innermost thermoplastic polymers layers may be applied by (co-)extrusion coating of the molten polymer to a desired thickness. According to another embodiment, the outer- and/ or innermost liquid-tight and heat sealable layers may be applied in the form of pre-manufactured, oriented or non-oriented films. The outermost heat-sealable, liquid-tight and protective thermoplastic polymer layer may alternatively be applied by means of an aqueous dispersion coating of a thermoplastic polymer, when only low thickness of such an outermost layer is desired, or when such a process is preferable for other reasons.

According to the process described by this invention various types of laminates suitable for liquid or semi-liquid packaging can be produced such as the following laminate: LDPE//release layer-organic barrier layer-adhesive-paper//blend LDPE+mLLDPE or LDPE//release layer-organic barrier layer-adhesive-PE//blend LDPE+mLLDPE

### Generally preferred embodiments

In a further preferred embodiment, the organic barrier layer in the multilayer structure according to this invention consists of melamine.

In a yet further preferred embodiment, the organic barrier layer in the multilayer structure according to this invention consists of layers of PVOH and of melamine.

In a yet further preferred embodiment, the organic barrier layer in the multilayer structure according to this invention consists of layers of PVOH with nanoclay and of melamine.

In a further preferred embodiment, the organic barrier layer in the multilayer structure according to this invention consists of melamine and a metallized aluminum layer.

In a further preferred embodiment, the adhesive in the multilayer structure according to this invention consists of adhesive polymers of the type described above applied by extrusion.

In a further preferred embodiment, after applying organic barrier layer on carrier film, the organic barrier layer is coated with a protective coating cured by means of UV or EB radiation.

In a further preferred embodiment, the release layer is vacuum deposited inline before vacuum deposition of organic barrier layer.

In a further preferred embodiment, substrate is metallized before lamination to the carrier film. It may be noted that this metallization directly on paper or polyolefin such as PE often is for decorative purposes. Metallization is also beneficial to induce UV barrier and allow sealing by induction heating or ultrasonic heating or other conventional contact or convection heating means, e.g. hot air.

In a further preferred embodiment, the metallized substrate is a cellulose based material such as paper before lamination to carrier film.

In a further preferred embodiment, the multilayer barrier composite prepared according to the present invention is printed with one of various techniques such as flexography and rotogravure, offset printing, inkjet printing, laser printing or other methods known in man skilled in the art. For printing various types of inks comprising a binder, a pigment, additives and solvents. The binder generally is a polymer like polyurethane, polyamide (PA), (PVB) Poly Vinyl Butyral, (CAB) cellulose acetate butyrate, (PVC) polyvinyl chloride, polyvinylalcohol (PVA) and polyacrylates (acrylic).

The, optionally printed, multilayer barrier composite prepared according to the present invention can be also optionally laminated with various sealants such as polyethylene using various types of adhesives, such as solvent based, solventless and water based.

### Properties of the multilayer structures

The multilayer structure prepared according the invention has favorable barrier properties.

The multilayer structure according the invention comprises
a. a substrate chosen from paper, paperboard or other cellulose based material, or polyolefin such as polyethylene or polypropylene
b. an adhesive layer
c. an organic barrier layer comprising an organic barrier compound, and
d. optionally a release layer

More in particular, the multilayer structure according the invention consists of
a. a substrate chosen from paper, paperboard or other cellulose based material, or polyethylene
b. an adhesive layer
c. an organic barrier layer consisting essentially of a crystalline organic barrier compound, and
d. optionally a release layer
wherein the multilayer structure has an OTR of 100 cc/m²·24 hr or lower, preferably of about 50 cc/m²·24 hr or lower.

Generally, substrates from cellulose materials, or from PE cannot be provided with an effective barrier layer with direct vapor deposition of crystalline organic compounds. If PE is directly provided with a melamine barrier layer, an OTR can be found of not lower than 300 cc/m²·24 hr, while the OTR with cellulose based materials is even higher. With the process of the invention, it appears possible to obtain favourable OTR values on these substrates of about 100 cc/m²·24 hr or lower, like about 50 cc/m²·24 hr or lower, and even about 30 cc/m²·24 hr or lower.

In this embodiment, the organic barrier layer preferably consists of a crystalline organic barrier compound.

Preferably, the organic barrier layer is a crystalline triazine, preferably crystalline melamine.

With respect to the favorable properties, specifically the oxygen transmission rate (OTR) and water vapor permeability (WVP) are of interest.

The OTR is generally measured in an atmosphere of 20-30° C. (for example 23° C.) and between 0% and 85% RH. The preferred values generally depend on the substrate. In case the substrate is paper, paper board or other cellulose based material, the OTR generally will be about 400 cc/m²·24 hr or less, preferably about 300 cc/m²·24 hr or less and even more preferred about 200 cc/m²·24 hr or less. Even more preferred values are an OTR of 100 cc/m²·24 hr or lower, preferably of about 50 cc/m²·24 hr or lower. Generally, in case of paper, paper board or other cellulose based material, the OTR will be about 0.1 cc/m²·24 hr or higher, and for example may be about 1 cc/m²·24 hr or higher.

The OTR can be measured with suitable apparatus, such as for example with an OXTRAN 2/20 manufactured by Modern Control Co.

In case the substrate is a polyolefin such as PE, the OTR generally will be about 100 cc/m²·24 hr or less, preferably about 50 cc/m²·24 hr or less, and even more preferably about 30 cc/m²·24 hr or less and even more preferred about 10 cc/m²·24 hr or less. Generally, in case of PE, the OTR will be about 0.3 cc/m²·24 hr or higher, and for example may be about 0.5 or 1 cc/m²·24 hr or higher

Water vapor permeability (WVTR) can be measured with a PERMATRAN 3/31 manufactured by Modern Control Co, in an atmosphere of 25-40° C and between 50 and 90% RH.

The preferred values will depend on the substrate. For example, in case the substrate is paper, paper board or other cellulose based material, the WVTR is generally about 3 g/m²·24 h or less, preferably about 2 g/m²·24 h or less, and more preferably about 1 g/m²·24 h or less.

Generally, the vapor permeability will be about 0.1 g/m²·24 h or more, for example about 0.2 g/m²·24 h or more. In case the substrate is a polyolefin such as PE, the WVTR is generally about 8 g/m²·24 h or less, preferably about 7 g/m²·24 h or less, and more preferably about 4 g/m²·24 h or less. Generally, the vapor permeability will be about 0.5 g/m²·24 h or more, for example about 2 g/m²·24 h or more.

Preferably, the laminate has an OTR and WVTR also for other substrates which conforms to the values given in the former six paragraphs.

### Examples

As the carrier film a 12 micron biaxially oriented polyester film (PET) was coated with different release layers as shown in table 1. Subsequently a layer of melamine was deposited onto release layer under vacuum at a pressure of 10⁻⁴ Pa and a deposition temperature of 310°C. Melamine coated PET film was then laminated with a solventless adhesive onto two different types of substrates, i.e. 250 gr paper and 100 micron LDPE. After the adhesive was sufficiently cured, the laminate was then stripped resulting in the transfer of melamine coating onto the substrate. Table 1 shows OTR values of two different substrates coated with melamine using various release layers.

**Table 1. Oxygen Transmission Rates (OTR) of 250 gr paper and 100 micron LDPE with a vapor deposited melamine transferred onto these substrates using different release layers.**

| Release Layer | OTR (cc/m²·24 hr)^{*)} | |
|---|---|---|
| | LDPE | Paper |
| Doresco^{®} RA7346 | 20.5 | 34.3 |
| Aquaslip^{™} 958 | 13.7 | 10.8 |
| 00-WQ-25 | 24.8 | 7.8 |
| Aluminum (OD=3.5)^{**)} | 9.5 | 3.4 |

| | | |
|---|---|---|
| *) OTR value of plain LDPE film is above 3000 cc/m²·24 hr. OTR value of 250 gram paper is not measurable. **) PET film was aluminum metallized resulting in optical density (OD) of 3.5. | | |

## Claims

1. A method for producing a multilayer structure comprising an organic barrier layer, adhesive layer and substrate, comprising the following steps
(a) providing a carrier film,
(b) wherein a major part of the surface of the carrier film is provided with a release agent chosen from (i) an organic release layer, which organic release layer has the capacity to effect a releasable bond from the surface of the carrier film and a non-releasable bond with the surface of an organic barrier layer to be applied on the release layer and/or (ii) a metal layer on the carrier film which adheres stronger to the carrier film than to the organic barrier layer,
(c) providing an organic barrier layer on the release agent,
(d) providing an adhesive layer on the organic barrier layer, and bonding the organic barrier layer with said adhesive to a substrate, and
(e) stripping said carrier film to form the multilayer structure.

2. The method according to claim 1, wherein the substrate is a biodegradable, bio-based substrate or a polyolefin substrate.

3. The method according to any one of claims 1-2 wherein the organic barrier layer is applied by vacuum deposition.

4. The method according to claim 3 whereby the organic barrier layer is a crystalline organic compound.

5. The method according to claim 4 whereby the organic barrier layer comprises a triazine compound, preferably melamine, melam, melem, or melon, preferably the organic barrier layer consists of melamine, preferably crystalline melamine.

6. The method according to any one of claims 2-5 whereby the organic barrier layer is vacuum deposited on a metallic carrier film, preferably metalized PET or aluminum foil either with or without lamination onto PET.

7. The method according to any one of claims 1-6 whereby the organic barrier layer is vacuum deposited on an organic release layer as release agent.

8. A method for producing a multilayer structure according to any one of claims 1-7 whereby the organic barrier layer is applied by liquid deposition.

9. A method for producing a multilayer structure according to claim 8 whereby the organic barrier layer is selected from the group consisting of vinyl alcohol-based polymers, such as PVOH or water dispersible EVOH, polysaccharides such as for example starch or starch derivatives, microfibrillated cellulose (MFC), cellulose nanofibrils (CNF), nanocrystalline cellulose (NCC), hemicellulose or chitosan or other cellulose derivatives, water dispersible polyvinylidenechloride (PVDC) or water dispersible polyesters, or combinations of two or more thereof.

10. A method for producing a multilayer structure according to any one of claims 1-9 wherein the substrate is paper, paperboard or other cellulose based material.

11. A method for producing a multilayer structure according to any one of claims 1-10 wherein the substrate comprises polyolefin such as polyethylene.

12. Use of multilayer structure obtained with a process according to any one of claims 1-11 in food and non-food packaging.

## Patentansprüche

1. Verfahren zum Herstellen einer Mehrschichtstruktur, die eine organische Sperrschicht, eine Klebstoffschicht und ein Substrat umfasst, umfassend die folgenden Schritte
(a) Bereitstellen eines Trägerfilms,
(b) wobei ein größerer Teil der Oberfläche des Trägerfilms mit einem Trennmittel bereitgestellt ist, das ausgewählt ist aus (i) einer organischen Trennschicht, wobei die organische Trennschicht die Fähigkeit hat, eine ablösbare Bindung von der Oberfläche des Trägerfilms und eine nicht ablösbare Bindung mit der Oberfläche einer organischen Sperrschicht, die auf die Trennschicht aufgebracht werden soll, zu bewirken, und/oder (ii) einer Metallschicht auf dem Trägerfilm, die stärker an dem Trägerfilm haftet als an der organischen Sperrschicht,
(c) Bereitstellen einer organischen Sperrschicht auf dem Trennmittel,
(d) Bereitstellen einer Klebstoffschicht auf der organischen Sperrschicht und Binden der organischen Sperrschicht mit dem Klebstoff mit einem Substrat und
(e) Ablösen des Trägerfilms von der Mehrschichtstruktur.

2. Verfahren nach Anspruch 1, wobei das Substrat ein biologisch abbaubares, biobasiertes Substrat oder ein Polyolefinsubstrat ist.

3. Verfahren nach einem der Ansprüche 1 bis 2, wobei die organische Sperrschicht durch Vakuumabscheidung aufgebracht wird.

4. Verfahren nach Anspruch 3, wobei die organische Sperrschicht eine kristalline organische Verbindung ist.

5. Verfahren nach Anspruch 4, wobei die organische Sperrschicht eine Triazinverbindung, vorzugsweise Melamin, Melam, Melem oder Melon, umfasst, wobei die organische Sperrschicht vorzugsweise aus Melamin, vorzugsweise kristallinem Melamin, besteht.

6. Verfahren nach einem der Ansprüche 2 bis 5, wobei die organische Sperrschicht im Vakuum auf einen metallischen Trägerfilm, vorzugsweise metallisiertes PET oder Aluminiumfolie, entweder mit oder ohne Laminierung auf PET aufgebracht wird.

7. Verfahren nach einem der Ansprüche 1 bis 6, wobei die organische Sperrschicht im Vakuum auf eine organische Trennschicht als Trennmittel aufgebracht wird.

8. Verfahren zum Herstellen einer Mehrschichtstruktur nach einem der Ansprüche 1-7, wobei die organische Sperrschicht durch Flüssigkeitsabscheidung aufgebracht wird.

9. Verfahren zum Herstellen einer Mehrschichtstruktur nach Anspruch 8, wobei die organische Sperrschicht ausgewählt ist aus der Gruppe, bestehend aus Polymeren auf Vinylalkoholbasis, wie PVOH oder wasserdispergierbarem EVOH, Polysacchariden, wie zum Beispiel Stärke oder Stärkederivate, mikrofibrillierter Cellulose (MFC), Cellulose-Nanofibrillen (CNF), nanokristalliner Cellulose (NCC), Hemicellulose oder Chitosan oder anderen Cellulosederivaten, wasserdispergierbarem Polyvinylidenchlorid (PVDC) oder wasserdispergierbaren Polyestern oder Kombinationen von zwei oder mehreren davon.

10. Verfahren zum Herstellen einer Mehrschichtstruktur nach einem der Ansprüche 1-9, wobei das Substrat Papier, Pappe oder ein anderes Material auf Zellulosebasis ist.

11. Verfahren zum Herstellen einer Mehrschichtstruktur nach einem der Ansprüche 1-10, wobei das Substrat ein Polyolefin, wie zum Beispiel Polyethylen, umfasst.

12. Verwendung einer Mehrschichtstruktur, die mit einem Verfahren nach einem der Ansprüche 1 bis 11 erhalten wurde, in Verpackungen für Lebensmittel und Nicht-Lebensmittel.

## Revendications

1. Procédé de production d'une structure multicouche comprenant une couche barrière organique, une couche adhésive et un substrat, comprenant les étapes suivantes :
(a) la fourniture d'un film support,
(b) une partie majeure de la surface du film support étant pourvue d'un agent de séparation choisi parmi (i) une couche de séparation organique, laquelle couche de séparation organique a la capacité d'effectuer une liaison détachable de la surface du film support et une liaison non détachable avec la surface d'une couche barrière organique à appliquer sur la couche de séparation et/ou (ii) une couche métallique sur le film support qui adhère plus fortement au film support qu'à la couche barrière organique,
(c) la fourniture d'une couche barrière organique sur l'agent de séparation,
(d) la fourniture d'une couche adhésive sur la couche barrière organique, et la liaison de la couche barrière organique avec ledit adhésif à un substrat, et
(e) le retrait dudit film support pour former la structure multicouche.

2. Procédé selon la revendication 1, dans lequel le substrat est un substrat biodégradable, d'origine biologique ou un substrat polyoléfinique.

3. Procédé selon l'une quelconque des revendications 1 à 2, dans lequel la couche barrière organique est appliquée par dépôt sous vide.

4. Procédé selon la revendication 3, dans lequel la couche barrière organique est un composé organique cristallin.

5. Procédé selon la revendication 4, dans lequel la couche barrière organique comprend un composé triazine, de préférence la mélamine, le mélam, le mélem ou le melon, de préférence la couche barrière organique est constituée de mélamine, de préférence de mélamine cristalline.

6. Procédé selon l'une quelconque des revendications 2 à 5, dans lequel la couche barrière organique est déposée sous vide sur un film support métallique, de préférence du PET métallisé ou une feuille d'aluminium, avec ou sans laminage sur du PET.

7. Procédé selon l'une quelconque des revendications 1 à 6, dans lequel la couche barrière organique est déposée sous vide sur une couche de séparation organique servant d'agent de séparation.

8. Procédé de fabrication d'une structure multicouche selon l'une quelconque des revendications 1 à 7, dans lequel la couche barrière organique est appliquée par dépôt liquide.

9. Procédé de fabrication d'une structure multicouche selon la revendication 8, dans lequel la couche barrière organique est choisie dans le groupe constitué par les polymères à base d'alcool vinylique, tels que le PVOH ou l'EVOH dispersible dans l'eau, les polysaccharides tels que par exemple l'amidon ou les dérivés d'amidon, la cellulose microfibrillée (MFC), les nanofibrilles de cellulose (CNF), la cellulose nanocristalline (NCC), l'hémicellulose ou le chitosane ou d'autres dérivés de cellulose, le polychlorure de vinylidène dispersible dans l'eau (PVDC) ou les polyesters dispersibles dans l'eau, ou des combinaisons de deux ou plus de ceux-ci.

10. Procédé de production d'une structure multicouche selon l'une quelconque des revendications 1 à 9, dans lequel le substrat est du papier, du carton ou un autre matériau à base de cellulose.

11. Procédé de production d'une structure multicouche selon l'une quelconque des revendications 1 à 10, dans lequel le substrat comprend une polyoléfine telle que le polyéthylène.

12. Utilisation d'une structure multicouche obtenue par un procédé selon l'une quelconque des revendications 1 à **11** dans des emballages alimentaires et non alimentaires.
